# EUROPEAN PATENT APPLICATION

(11) **EP 4 803 973 A1**
(43) Date of publication of application: **09.09.2026**
(21) Application number: 24913442.0
(22) Date of filing: 27.12.2024
(51) Int. Cl.: G06F 1/16, G02B 1/14

(54) **ELECTRONIC DEVICE INCLUDING MOLDING PORTION**

(30) Priority: 28.12.2023 KR 20230195576; 16.01.2024 KR 20240007013; 01.04.2024 KR 20240044219
(71) Applicant: Samsung Electronics Co., Ltd., Suwon-si, Gyeonggi-do 16677 (KR)
(72) Inventor: KIM, Junyoung, Suwon-si, Gyeonggi-do 16677 (KR); CHOI, Byungchul, Suwon-si, Gyeonggi-do 16677 (KR); KIM, Ilyoung, Suwon-si, Gyeonggi-do 16677 (KR)
(74) Representative: Gulde & Partner
(86) International application number: PCT/KR2024/021213
(87) International publication number: WO 2025/143835

(57) **Abstract**

An electronic device according to an embodiment of the disclosure may include a housing, a display placed in the housing, and a molding part provided at an end portion of the display. The display may include a panel layer including a bending area in at least a portion of an end portion, and a protective layer disposed on the panel layer. The protective layer may include a first concave area where at least a portion of an end portion of the protective layer is formed concavely, and the molding part may be disposed to fill the first concave area.

## Description

### [Technical Field]

The disclosure relates to an electronic device including a molding part.

### [Background Art]

An electronic device may include a molding part disposed at an end of a display. The molding part may be disposed to surround a bending area of the display formed at the end of the display. The bending area may be an area where the display bends and extends from a chip-on-panel (COP) portion located at the end of the display.

A waterproof tape may be disposed between the lower end of the molding part and the housing. The molding part may be coupled to the housing using the waterproof tape. When the waterproof tape is disposed on the molding part, a black masking (BM) area of the electronic device may be reduced.

The above-described information may be provided as related art for the purpose of assisting in understanding the disclosure. None of the foregoing might be asserted as prior art relevant to the disclosure or used for determination on prior art.

### [Disclosure of Invention]

### [Technical Problem]

When a molding part is placed in an end portion of a display of an electronic device, an air gap between the end portion of the display and other components of the electronic device may be reduced. When an impact is applied to the electronic device (e.g., when the electronic device is impacted by being dropped), the panel layer of the display may be damaged due to the reduction of the air gap. Since the opposite ends of a bending area of the display are vulnerable to an impact, it may be necessary to cushion the corresponding areas.

### [Solution to Problem]

According to an embodiment of the disclosure, an electronic device may include a housing, a display, and a molding part.

In an embodiment, the display may be placed in the housing.

In an embodiment, the molding part may be provided at an end portion of the display.

In an embodiment, the display may include a panel layer including a bending area in at least a portion of an end portion, and a protective layer disposed on the panel layer.

In an embodiment, the protective layer may include a first concave area where at least a portion of an end portion of the protective layer is formed concavely.

In an embodiment, the molding part may be disposed to fill the first concave area.

In an embodiment, the housing may include a placement space and a side wall surrounding the placement space.

In an embodiment, the display may be placed in the placement space and face the side wall.

In an embodiment, the molding part may be provided at the end portion of the display.

In an embodiment, the display may include a panel layer and a protective layer disposed on the panel layer.

In an embodiment, the molding part may include a first molding area provided at an end of the panel layer and a second molding area provided at an end of the protective layer.

In an embodiment, a first distance between the side wall and the first molding area may be longer than a second distance between the side wall and the second molding area.

### [Advantageous Effects of Invention]

In the electronic device according to an embodiment of the disclosure, a molding stopper structure (e.g., the convex area of the molding part) with a reverse step structure is applied to each end of the bending area. As a result, it is possible to prevent or suppress the display from moving relative to the molding part when an impact is applied to the electronic device.

In the electronic device according to an embodiment of the disclosure, a molding stopper structure (e.g., the convex area of the molding part) with a reverse step structure is applied to each end of the bending area. As a result, it is possible to prevent or suppress the display from being damaged due to the movement of the display.

In the electronic device according to an embodiment of the disclosure, the step area is provided on a portion of the side wall of the housing. As a result, it is possible to prevent or suppress an impact from being directly applied to the panel layer of the display.

### [Brief Description of Drawings]

FIG. 1 is a block diagram of an electronic device according to an embodiment in a network environment.
FIGS. 2A and 2B are perspective views of an electronic device according to an embodiment of the disclosure.
FIG. 3 is an exploded perspective view of the electronic device according to an embodiment of the disclosure.
FIG. 4 is a view illustrating an electronic device according to an embodiment of the disclosure.
FIG. 5 is a view illustrating an electronic device according to an embodiment of the disclosure.
FIGS. 6A to 6C are views illustrating an electronic device according to an embodiment of the disclosure.
FIGS. 7A to 7C are views illustrating a molding part according to an embodiment of the disclosure.
FIG. 8 is a cross-sectional perspective view of a display according to an embodiment of the disclosure.
FIGS. 9A to 9D are views illustrating a display according to an embodiment of the disclosure.
FIG. 10 is a view illustrating a protective layer according to an embodiment of the disclosure.
FIGS. 11A and 11B are views illustrating a side wall of a housing according to an embodiment of the disclosure.
FIGS. 12 and 13 are views illustrating an electronic device according to an embodiment of the disclosure.

### [Mode for the Invention]

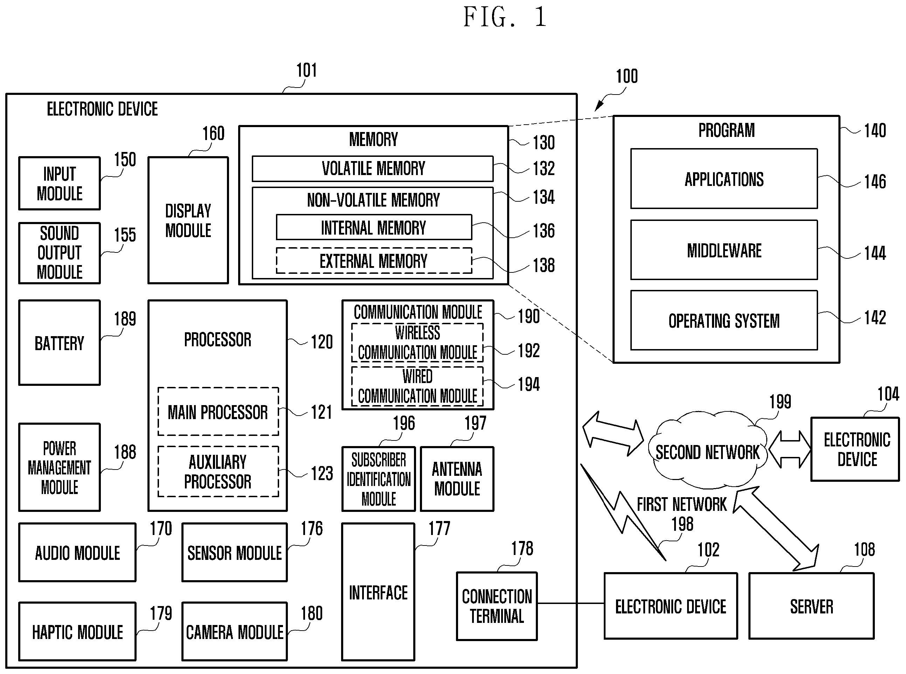

Fig. 1 is a block diagram illustrating an electronic device 101 in a network environment 100 according to various embodiments. Referring to Fig. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

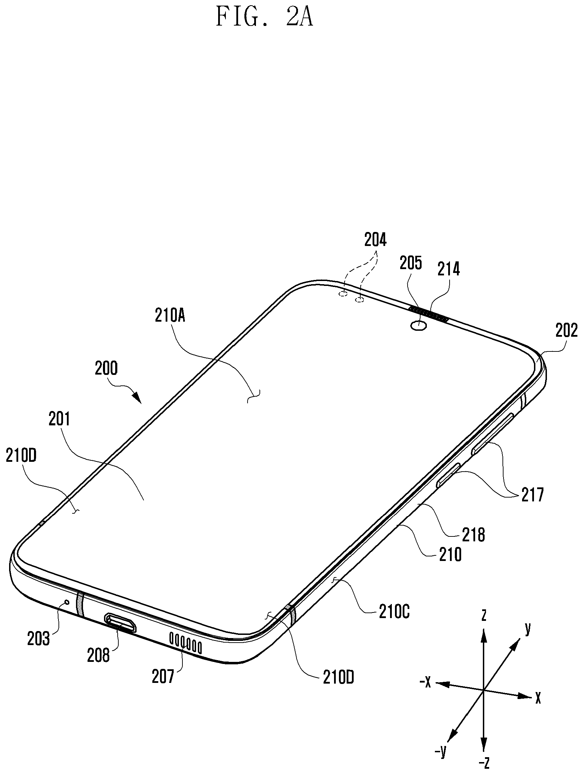

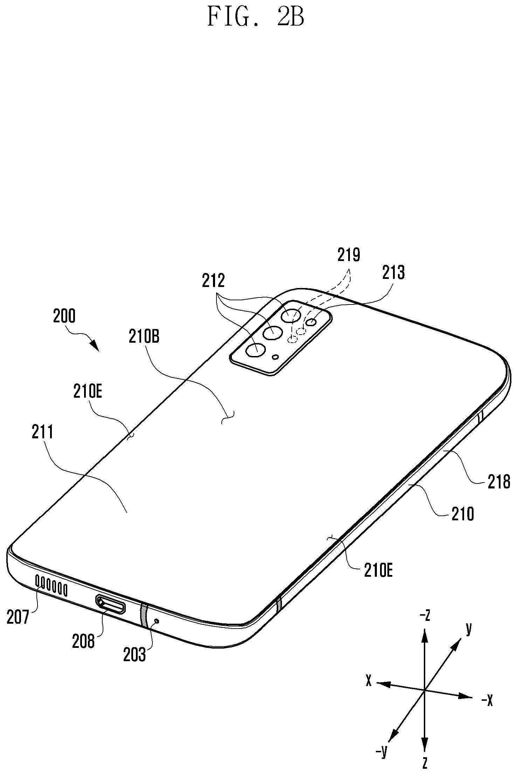

FIG. 2A is a front perspective view of an electronic device 200 according to an embodiment of the disclosure. FIG. 2B is a rear perspective view of the electronic device 200 of FIG. 2A according to an embodiment of the disclosure.

The electronic device 200 of FIGS. 2A and 2B may be at least partially similar to the electronic device 101 of FIG. 1, or may include at least some of the components of the electronic device 101.

Referring to FIGS. 2A and 2B, the electronic device 200 according to an embodiment may include a housing 210 having a first surface (or a front surface) 210A, a second surface (or a rear surface) 210B, and a side surface 210C surrounding the space between the first surface 210A and the second surface 210B. In an embodiment (not illustrated), the term "housing 210" may refer to a structure defining a part of the first surface 210A, the second surface 210B, and the side surface 210C. According to an embodiment, at least a portion of the first surface 210A may be defined by a substantially transparent front surface plate 202 (e.g., a glass plate or a polymer plate with various coating layers). The second surface 210B may be defined by a substantially opaque rear surface plate 211. The rear surface plate 211 may be made of, for example, coated or colored glass, ceramic, polymer, metal (e.g., aluminum, stainless steel (STS), or magnesium), or a combination of two or more of these materials. The side surface 210C may be defined by a side surface bezel structure (or a "side surface member") 218 coupled to the front surface plate 202 and the rear surface plate 211 and including metal and/or polymer. In some embodiments, the rear surface plate 211 and the side surface bezel structure 218 may be integrally configured and may include the same material (e.g., a metal material such as aluminum).

In the illustrated embodiment, the front surface plate 202 may include, at the opposite long edges thereof, first areas 210D, which are bent from the first surface 210A toward the rear surface plate and extend seamlessly. In the illustrated embodiment (see FIG. 2B), the rear surface plate 211 may include, at the opposite long edges thereof, second areas 210E, which are bent from the second surface 210B toward the front surface plate and extend seamlessly. In some embodiments, the front surface plate 202 or the rear surface plate 211 may include only one of the first areas 210D or the second areas 210E. In some embodiments, the front surface plate 202 may not include the first areas and the second areas, and may include only a flat surface arranged in parallel to the second surface 210B. In the above-described embodiments, when viewed from a side of the electronic device, the side surface bezel structure 218 may have a first thickness (or width) on the side surfaces where the first areas 210D or the second areas 210E are not included, and may have a second thickness smaller than the first thickness, on the side surfaces where the first areas or the second areas are included.

According to an embodiment, the electronic device 200 may include at least one of a display 201, an input device 203, sound output devices 207 and 214, sensor modules 204 and 219, camera modules 205, 212, and 213, key input devices 217, an indicator (not illustrated), or a connector 208. In some embodiments, in the electronic device 200, at least one of the components (e.g., the key input devices 217 or the indicator) may be omitted, or other components may be additionally included.

The display 201 may be exposed through a substantial portion of, for example, the front surface plate 202. In some embodiments, the display 201 may be at least partially exposed through the front surface plate 202, which defines the first surface 210A and the first areas 210D of the side surface 210C. The display 201 may be coupled to or disposed adjacent to a touch detection circuit, a pressure sensor configured to measure a touch intensity (pressure), and/or a digitizer configured to detect a magnetic field-type stylus pen. In some embodiments, at least some of the sensor modules 204 and 219 and/or at least some of the key input devices 217 may be disposed in the first areas 210D and/or the second areas 210E.

The input device 203 may include a microphone. In some embodiments, the input device 203 may include a plurality of microphones arranged to detect the direction of sound. The sound output devices 207 and 214 may include speakers. The speakers may include an external speaker 207 and a call receiver 214. In some embodiments, the microphone, the speakers, and the connector 208 may be arranged in the space of the electronic device 200 and exposed to the external environment through at least one hole formed in the housing 210. In some embodiments, a hole formed in the housing 210 may be used jointly for the microphone and speakers. In some embodiments, the sound output devices 207 and 214 may include a speaker that operates without a hole in the housing 210 (e.g., a piezo speaker).

The sensor modules 204 and 219 may generate electrical signals or data values corresponding to an internal operating state or an external environmental state of the electronic device 200. The sensor modules 204 and 219 may include, for example, a first sensor module 204 (e.g., a proximity sensor), a second sensor module (not illustrated) (e.g., a fingerprint sensor) placed on the first surface 210A of the housing 210, and/or a third sensor module 219 (e.g., an HRM sensor) placed on the second surface 210B of the housing 210. The fingerprint sensor may be placed on the first surface 210A of the housing 210. The fingerprint sensor (e.g., an ultrasonic fingerprint sensor or an optical fingerprint sensor) may be disposed under the display 201 of the first surface 210A. The electronic device 200 may further include at least one of sensor modules (not illustrated), such as a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, or an illuminance sensor 204.

The camera modules 205, 212, and 213 may include a first camera device 205 disposed on the first surface 210A of the electronic device 200, and a second camera device 212 and/or a flash 213 disposed on the second surface 210B of the electronic device 100. The camera modules 205 and 212 may include one or more lenses, an image sensor, and/or an image signal processor. The flash 213 may include, for example, a light-emitting diode or a xenon lamp. In some embodiments, two or more lenses (e.g., a wide-angle lens and a telephoto lens) and image sensors may be disposed on one surface of the electronic device 200.

The key input devices 217 may be disposed on the side surface 210C of the housing 210. In an embodiment, the electronic device 200 may not include some or all of the above-mentioned key input devices 217, and key input devices 217, which are not included, may be implemented in another form, such as soft keys, on the display 201. In an embodiment, the key input devices 217 may be implemented using pressure sensors included in the display 201.

The indicator may be disposed, for example, on the first surface 210A of the housing 210. The indicator may provide, for example, the state information of the electronic device 200 in an optical form. In an embodiment, the light-emitting element may provide, for example, a light source that operates in conjunction with the operation of the camera module 205. The indicator may include, for example, an LED, an IR LED, and a xenon lamp.

The connector holes 208 may include a first connector hole 208 capable of accommodating a connector (e.g., a USB connector or an interface connector port (IF) module) configured to transmit/receive power and/or data to/from an external electronic device, and a second connector hole (or an earphone jack) capable of accommodating a connector configured to transmit/receive an audio signal to/from an external electronic device.

Some camera modules 205 among the camera modules 205 and 212, some sensor modules 204 among the sensor modules 204 and 219, or the indicator may be disposed to be exposed through the display 201. For example, the camera modules 205, the sensor modules 204, or the indicator may be disposed in the inner space of the electronic device 200 to be in contact with the external environment through an opening perforated in the display 201 up to the front surface plate 202 or a transmission area. According to an embodiment, the area where the display 201 and the camera modules 205 face each other may be configured as a transmission area with a predetermined transmittance as a portion of a content display area. According to an embodiment, the transmission area may have a transmittance ranging from about 5% to about 20%. The transmission area may include an area that overlaps with an effective area (e.g., a field of view area) of the camera module 205 through which light passes to form an image on the image sensor. For example, the transmission area of the display 201 may include an area having a lower pixel density than the periphery. For example, the transmission area may replace the opening. For example, the camera module 205 may include an under-display camera (UDC). As an embodiment, some sensor modules 204 may be placed in the inner space of the electronic device to perform the functions thereof without being visually exposed through the front surface plate 202. For example, in this case, the area of the display 201 facing the sensor module may not require a perforated opening.

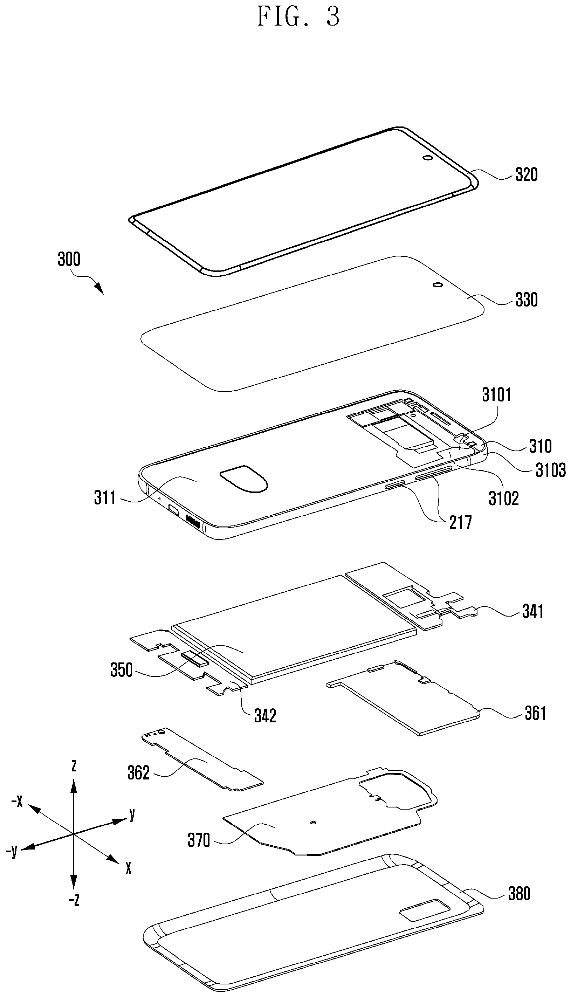

FIG. 3 is an exploded perspective view of the electronic device according to an embodiment of the disclosure.

The electronic device 300 of FIG. 3 may be at least partially similar to the electronic device 101 of FIG. 1 and/or the electronic device 200 of FIG. 2A, or may include some of the components of the electronic devices 101 and 200.

Referring to FIG. 3, the electronic device 300 (e.g., the electronic device 101 in FIG. 1 or the electronic device 200 in FIG. 2) may include a side surface member 310 (e.g., the side surface bezel structure 218 in FIG. 2A), a support member 311 (e.g., a bracket or a support structure), a front surface cover 320 (e.g., the front surface plate 202 in FIG. 2A), a display 330 (e.g., the display 201 in FIG. 2A), one or more substrates 341 and 342 (e.g., a printed circuit board (PCB), a flexible PCB (FPCB), or a rigid-flexible PCB (R-FPCB)), a battery 350, one or more additional support members 361 and 362 (e.g., a rear case), an antenna 370, and a rear surface cover 380 (e.g., the rear surface plate 211 in FIG. 2). In some embodiments, in the electronic device 300, at least one of the components (e.g., the support member 311 or one or more additional support members 361 and 362) may be omitted, or other components may be additionally included. At least one of the components of the electronic device 300 may be the same as or similar to at least one of the components of the electronic device 100 in FIG. 1 or the electronic device 200 in FIG. 2A, and a redundant description may be omitted below.

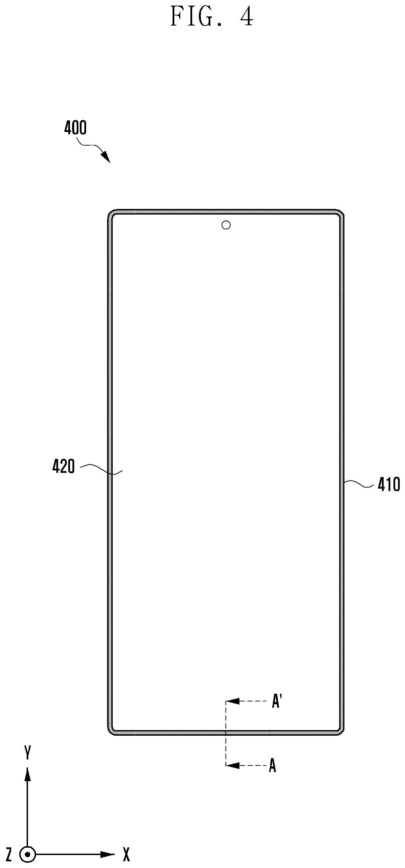

According to an embodiment, the side surface member 310 may include a first surface 3101 oriented in a first direction (e.g., the z-axis direction), a second surface 3102 oriented in a direction opposite to the first surface 3101, and a side surface 3103 surrounding the space (e.g., the inner space 4001 in FIG. 4) between the first surface 3101 and the second surface 3102. According to an embodiment, at least a portion of the side surface 3103 may define the exterior of the electronic device. According to an embodiment, the support member 311 may be disposed to extend from the side surface member 310 toward the inner space (e.g., the inner space 4001 in FIG. 4) of the electronic device 300. In some embodiments, the support member 311 may be disposed separately from the side surface member 310. According to an embodiment, the side surface member 310 and/or the support member 311 may be made of, for example, a metal material and/or a non-metal material (e.g., polymer). According to an embodiment, the support member 311 may support at least a portion of the display 330 via the first surface 3101, and may be disposed to support at least a portion of the one or more substrates 341 and 342 and/or a battery 350 via the second surface 3102. According to an embodiment, the one or more substrates 341 and 342 may include a first substrate 341 (e.g., a main substrate) disposed on one side of the battery 350 and a second substrate 342 (e.g., a sub-substrate) disposed on the other side, in the inner space of the electronic device 300. According to an embodiment, the first substrate 341 and/or the second substrate 342 may include a processor, memory, and/or an interface. According to an embodiment, the processor may include one or more of, for example, a central processing device, an application processor, a graphics processor, an image signal processor, a sensor hub processor, or a communication processor. According to an embodiment, the memory may include, for example, volatile memory or nonvolatile memory. According to an embodiment, the interface may include, for example, a high-definition multimedia interface (HDMI), a universal serial bus (USB) interface, an SD card interface, and/or an audio interface. The interface may electrically or physically connect, for example, the electronic device 300 to an external electronic device, and may include a USB connector, an SD card/MMC connector, or an audio connector. According to an embodiment, the battery 350 is a device configured to supply power to at least one component of the electronic device 300 and may include, for example, a non-rechargeable primary battery, a rechargeable secondary battery, or a fuel cell. At least a portion of the battery 350 may be disposed on substantially the same plane as, for example, the one or more substrates 341 and 342. According to an embodiment, the battery 350 may be disposed in a manner of being embedded in the electronic device 300. In some embodiments, the battery 350 may be disposed to be detachable from the electronic device 300.

According to an embodiment, the antenna 370 may be disposed between the rear surface cover 380 and the battery 350. According to an embodiment, the antenna 370 may include, for example, a near-field communication (NFC) antenna, a wireless charging antenna, and/or a magnetic secure transmission (MST) antenna. For example, the antenna 370 may execute short-range communication with an external device or may transmit/receive power required for charging to/from an external device in a wireless manner. In some embodiments, an antenna may be configured by a portion of the side surface member 310 and/or the support member 311, or a combination thereof. In some embodiments, the electronic device 300 may further include a digitizer configured to detect an external electronic pen.

FIG. 4 is a view illustrating an electronic device 400 according to an embodiment of the disclosure.

The electronic device 400 of FIG. 4 may refer to the electronic device 101 of FIG. 1 or may include at least some of the components of the electronic device 101 of FIG. 1.

The electronic device 300 of FIG. 4 may refer to the electronic devices 200 and 300 of FIGS. 2A and 2B and FIG. 3 or may include at least some of the components of the electronic devices 200 and 300 of FIGS. 2A and 2B and FIG. 3.

In describing the electronic device 400 according to an embodiment of the disclosure, the width direction of the electronic device 400 may refer to the X-axis direction, and the length direction of the electronic device 400 may refer to the Y-axis direction. The height direction of the electronic device 400 may refer to the Z-axis direction.

In an embodiment, the electronic device 400 may include a housing 410 and/or a window cover 420.

In an embodiment, the housing 410 may be substantially the same as the housing 210 of FIG. 2A.

In an embodiment, the housing 410 may define the exterior of the electronic device 400 and may provide a space in which components of the electronic device 400 are disposed. The components of the electronic device 400 may be disposed inside the housing 410.

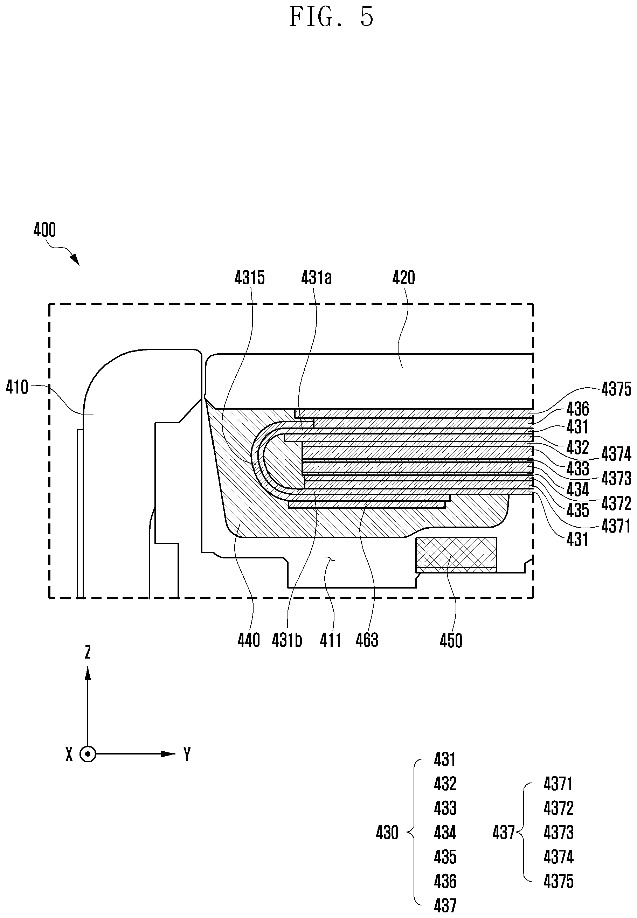

In an embodiment, the window cover 420 may be disposed on one surface of the display 430 (see FIG. 5). The window cover 420 may have substantially the same configuration as the front surface cover 320 of FIG. 3. The window cover 420 may serve to protect the display 430 (see FIG. 5).

FIG. 5 is a view illustrating the electronic device 400 according to an embodiment of the disclosure.

FIG. 5 is a cross-sectional view illustrating the electronic device 400 taken along line A-A' of FIG. 4.

In an embodiment, the electronic device 400 may include a housing 410, a window cover 420, a display 430, a molding part 440, and/or a waterproof member 450.

In an embodiment, the housing 410 may define the exterior of the electronic device 400 and may provide a space in which components of the electronic device 400 are disposed. For example, the housing 410 may include a placement space 411 in which components of the electronic device 400 are placed.

In an embodiment, the housing 410 may be made of metal (e.g., aluminum, stainless steel (STS), or magnesium).

In an embodiment, the display 430 may be placed in the housing 410. For example, the display 430 may be placed in the placement space 411 of the housing 410.

In an embodiment, the window cover 420 may be placed to cover at least a portion of the placement space 411 of the housing 410.

In an embodiment, the window cover 420 may be disposed on the display 430. The window cover 420 may be positioned in the +Z-axis direction with respect to the display 430.

In an embodiment, the window cover 420 may serve to protect the display 430.

In an embodiment, the display 430 may be a display module configured to visually provide information to the outside of the electronic device 400 (e.g., to the user).

In an embodiment, the display 430 may include at least one layer. In an embodiment, the display 430 may include a panel layer 431, a resin layer 432, a protective layer 433, a sensor layer 434, a shielding layer 435, a polarizing layer 436, and/or a bonding layer 437.

In an embodiment, the panel layer 431 may be a layer including a display panel.

In an embodiment, an area of the panel layer 431 may include an organic light-emitting diode OLED. For example, an OLED may be disposed in a portion of the area of the panel layer 431 facing the polarizing layer 436. The panel layer 431 is not limited to including an OLED, and in an embodiment, the panel layer 431 and the OLED may be disposed as separate layers.

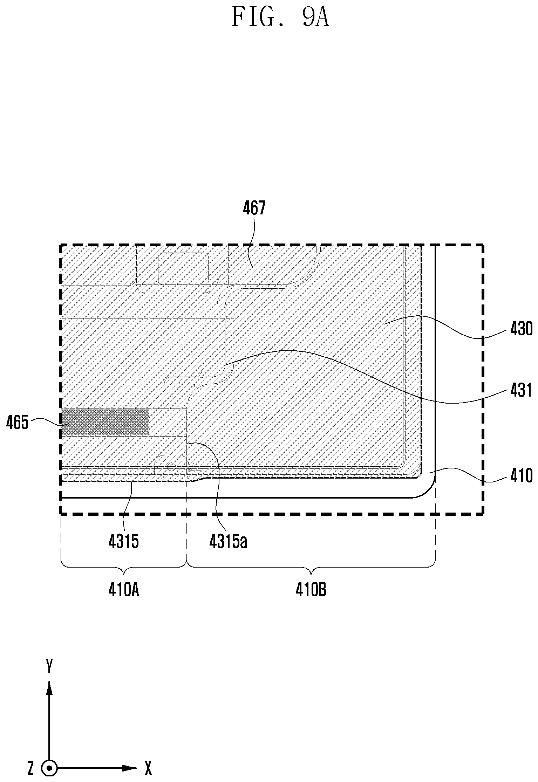

In an embodiment, the panel layer 431 may visually display information. Information may be visually displayed on the panel layer 431 by a control circuit (e.g., the control circuit 465 in FIG. 9A).

In an embodiment, the panel layer 431 may include a bending area 4315 that bends and extends. The bending area 4315 may be formed at an end of the panel layer 431 (e.g., the end of the panel layer 431 oriented in the -Y-axis direction 431).

In an embodiment, the bending area 4315 of the panel layer 431 may be an area where the display 430 bends and extends in a chip-on-panel (COP) portion located at the end of the display 430.

In an embodiment, the panel layer 431 may include a first area 431a and a second area 431b that is spaced apart from the first area 431a in the height direction of the display 430 (e.g., in the Z-axis direction). The bending area 4315 may connect the first area 431a and the second area 431b. The bending area 4315 may be an area that bends and extends to connect the first area 431a and the second area 431b.

In an embodiment, the shielding layer 435, the sensor layer 434, the protective layer 433, the resin layer 432, the panel layer 431, and the polarizing layer 436 may be laminated in the height direction of the display 430 (e.g., in the Z-axis direction). For example, the shielding layer 435, the sensor layer 434, the protective layer 433, the resin layer 432, the panel layer 431, and the polarizing layer 436 may be laminated in that order along the +Z-axis direction.

In an embodiment, the resin layer 432 may be disposed on the panel layer 431. In an embodiment, the resin layer 432 may include polyimide PI. The resin layer 432 may be positioned in the -Z-axis direction with respect to the portion of the panel layer 431 that is in contact with the polarizing layer 436.

In an embodiment, the protective layer 433 may be disposed on the resin layer 432. The protective layer 433 may serve to protect the panel layer 431 from impact applied to the panel layer 431. In an embodiment, the protective layer 433 may include an emboss sheet and/or a cushion sheet. The protective layer 433 may be positioned in the -Z-axis direction with respect to the resin layer 432.

In an embodiment, the sensor layer 434 may be disposed on the protective layer 433. The sensor layer 434 may include a sensor circuit that detects the operation of an external input device (e.g., a digital pen). For example, the sensor layer 434 may include a digitizer that detects input from a magnetic field type-stylus pen. The sensor layer 434 may be positioned in the -Z-axis direction with respect to the protective layer 433.

In an embodiment, the shielding layer 435 may be disposed on the sensor layer 434. The shielding layer 435 may serve to shield noise. The shielding layer 435 may include a copper (Cu) sheet. The shielding layer 435 may be positioned in the -Z-axis direction with respect to the sensor layer 434.

In an embodiment, the polarizing layer 436 may be disposed on the panel layer 431. The polarizing layer 436 may be disposed on the opposite side of the surface on which the resin layer 432 is disposed on the panel layer 431. The polarizing layer 436 may function as a polarizing plate.

In an embodiment, the bonding layer 437 may serve to bond respective layers included in the display 430 or bond the display 430 and the other components of the electronic device 400 to each other.

In an embodiment, the bonding layer 437 may include an adhesive material. For example, the bonding layer 437 may include at least one of an optical clear adhesive (OCA), a pressure-sensitive adhesive (PSA), a heat-reactive adhesive, a general adhesive, or a double-sided tape.

In an embodiment, the bonding layer 437 may include a first bonding layer 4371, a second bonding layer 4372, a third bonding layer 4373, a fourth bonding layer 4374, and/or a fifth bonding layer 4375.

In an embodiment, the first bonding layer 4371, the second bonding layer 4372, the third bonding layer 4373, the fourth bonding layer 4374, and the fifth bonding layer 4375 may serve to bond two layers positioned with the bonding layers 4371, 4372, 4373, 4374, and 4375 interposed therebetween.

In an embodiment, the first bonding layer 4371 may be disposed between the shielding layer 435 and the panel layer 431 (e.g., the second area 431b of the panel layer 431). The second bonding layer 4372 may be disposed between the shielding layer 435 and the sensor layer 434. The third bonding layer 4373 may be disposed between the sensor layer 434 and the protective layer 433. The fourth bonding layer 4374 may be disposed between the protective layer 433 and the resin layer 432. The fifth bonding layer 4375 may be disposed between the polarizing layer 436 and the window cover 420.

In an embodiment, the molding part 440 may be provided at an end portion of the display 430. The molding part 440 may be provided around the bending area 4315 of the panel layer 431 located in an end portion of the display 430.

In an embodiment, the molding part 440 may serve to protect the bending area 4315 of the panel layer 431. In an embodiment, the molding part 440 may serve to reinforce the rigidity of the bending area 4315.

In an embodiment, the outer surface of the bending area 4315 may refer to the surface facing the housing 410 and/or the window cover 420 in the bending area 4315. The inner surface of the bending area 4315 may mean an opposite surface of the outer surface of the bending area 4315. In an embodiment, the molding part 440 may be disposed on the outer and inner surfaces of the bending area 4315.

In an embodiment, the molding part 440 may be formed by curing a molding material. For example, the molding material may be injected around the end portion of the display 430, and the injected molding material may be cured to form the molding part 440.

In an embodiment, the molding part 440 may include silicone, epoxy, and/or poly methyl methacrylate (PMMA).

In an embodiment, a cover member 463 may be disposed on the panel layer 431. The cover member 463 may be disposed to cover a control circuit (e.g., the control circuit 465 in FIG. 9A). In an embodiment, the cover member 463 may be a tape disposed to cover the control circuit (e.g., the control circuit 465 in FIG. 9A).

In an embodiment, the waterproof member 450 may be disposed between the molding part 440 and the housing 410. The waterproof member 450 may have a waterproof material and may include an adhesive material. For example, the waterproof member 450 may include a waterproof tape having a waterproof material.

In an embodiment, the waterproof member 450 may serve to seal the space between the molding part 440 and the housing 410 to prevent or suppress foreign substances from entering the electronic device 400.

In FIG. 5, the waterproof member 450 is illustrated as not being attached to the molding part 440, but this is an example. According to an embodiment, the waterproof member 450 may be disposed in the housing 410 in a form attached to the molding part 440.

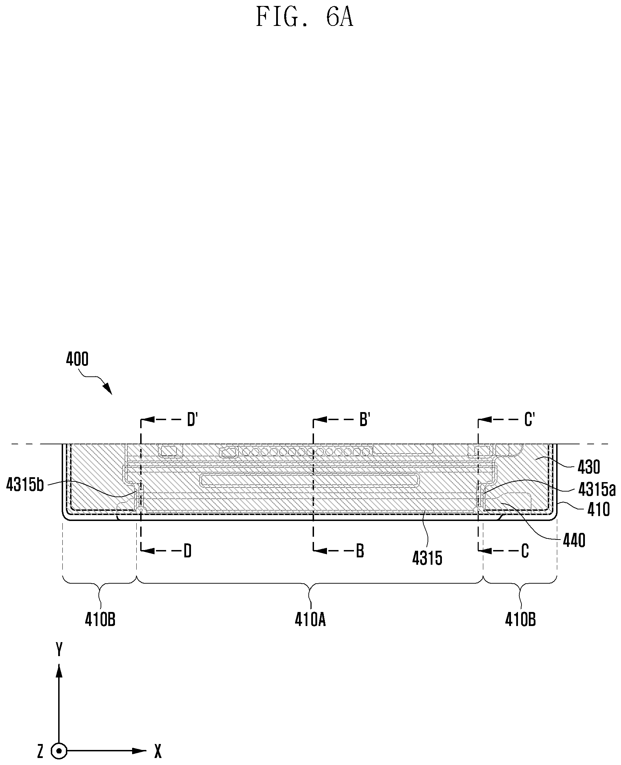

FIGS. 6A to 6C are views illustrating an electronic device 400 according to an embodiment of the disclosure.

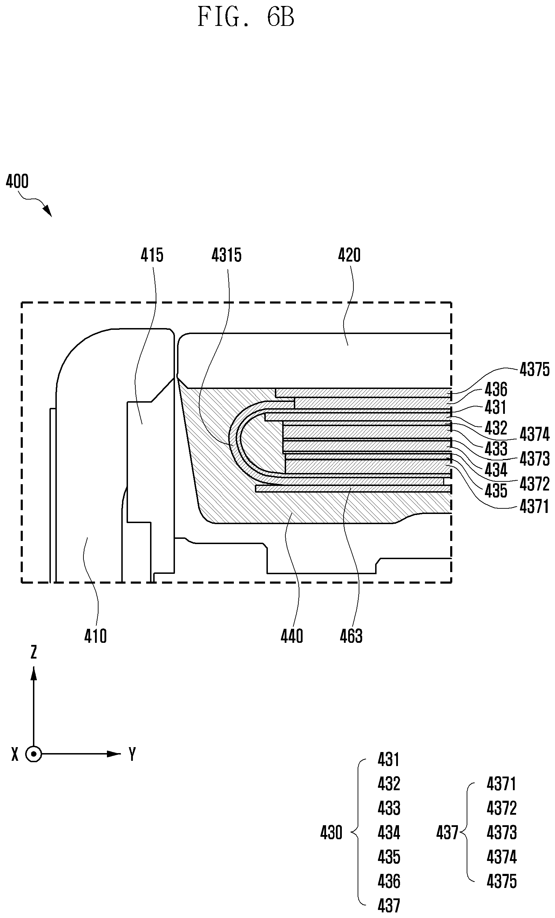

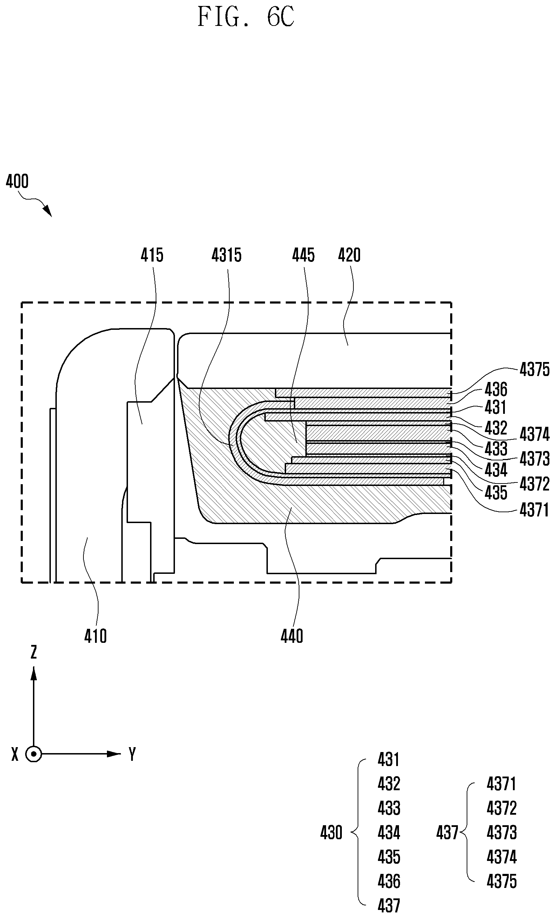

FIG. 6A may be a view illustrating an end portion (e.g., the end portion in the -Y-axis direction) of the electronic device 400. FIG. 6B is a cross-sectional view of the electronic device 400, taken along line B-B' of FIG. 6A. FIG. 6C is a cross-sectional view of the electronic device 400, taken along line C-C' or line D-D' of FIG. 6B.

Referring to FIG. 6A, the electronic device 400 may include a housing 410, a display 430, and/or a molding part 440.

Referring to FIG. 6A, the bending area 4315 of the display 430 may extend from a first end 4315a to a second end 4315b along the length direction of the bending area 4315 (e.g., the X-axis direction). In an embodiment, the first end 4315a may be an end located opposite to the second end 4315b.

In an embodiment, the length direction of the bending area 4315 may refer to the direction in which the bending area 4315 is relatively long. For example, the length direction of the bending area 4315 may refer to the X-axis direction.

The ends 4315a and 4315b of the bending area 4315 may be portions vulnerable to an impact. The ends 4315a and 4315b of the bending area 4315 are provided at positions that overlap with the molding part 440 and may be vulnerable to an external impact. For example, when an impact is applied to the electronic device 400, the ends 4315a and 4315b of the bending area 4315 may collide with the molding part 440 and damage the panel layer 431 of the display 430.

The electronic device 400 according to an embodiment of the disclosure may include a convex area 445 of the molding area 440 that is disposed at a position that overlaps with each end 4315a or 4315b of the bending area 4315 and performs a stopper function. For example, the convex area 445 of the molding part 440 may serve to prevent the display 430 from moving in the length direction (e.g., the Y-axis direction) and the width direction (e.g., the X-axis direction) of the electronic device 400 relative to the molding part 440. According to an embodiment, the electronic device 400 is configured such that the display 430 is prevented from moving relative to the molding part 440. Thus, when an external impact is applied to the electronic device 400, the impact applied to the display 430 may be reduced.

Referring to FIG. 6A, in an embodiment, a first part 410A of the housing 410 may be a portion of the housing 410 that faces the bending area 4315 of the display 430. For example, the first part 410A of the housing 410 may overlap with the bending area 4315. A second part 410B of the housing 410 may be a portion of the housing 410 that does not face the bending area 4315. For example, the second part 410B of the housing 410 may not overlap with the bending area 4315.

Referring to FIGS. 6A to 6C, the molding part 440 may be disposed in an end portion of the display 430.

In an embodiment, the molding part 440 may be formed by curing a molding material (e.g., silicone, epoxy, and/or poly methyl methacrylate (PMMA)) in an end portion of the display 430.

In an embodiment, the bending area 4315 of the panel layer 431 may extend along the width direction of the electronic device 400 (e.g., the X-axis direction). For example, the bending area 4315 may extend along the X-axis direction from the first end 4315a to the second end 4315b.

In an embodiment, the central portion of the bending area 4315 may refer to a portion located at the center of the bending area 4315 based on the length direction of the bending area 4315 (e.g., the X-axis direction). The central portion of the bending area 4315 may be a portion that is not adjacent to but spaced apart from the opposite ends 4315a and 4315b of the bending area 4315.

FIG. 6B may be a view illustrating the electronic device 400 viewed along line B-B' in FIG. 6A from a position that is not adjacent to the opposite ends of the bending area 4315 (e.g., the central portion of the bending area 4315).

In an embodiment, the protective layer 433 and the sensor layer 434 may extend longer in the length direction of the electronic device 400 (e.g., the -Y-axis direction) compared to the shielding layer 435 and the first bonding layer 4371 at a position that is not adjacent to the opposite ends of the bending area 4315 (e.g., the central portion of the bending area 4315). For example, referring to FIG. 6B, at locations that overlap with the central portion of the bending area 4315, the ends of the protective layer 433 and the sensor layer 434 may extend longer toward the side wall 415 of the housing 410 compared to the ends of the shielding layer 435 and the first bonding layer 4371 in the length direction of the electronic device 400 (e.g., in the -Y-axis direction).

In FIG. 6B, at a position that is not adjacent to the opposite ends of the bending area 4315 (e.g., the central portion of the bending area 4315), the protective layer 433 and the sensor layer 434 are illustrated as extending longer compared to the shielding layer 435 and the first bonding layer 4371 at locations that are not adjacent to the ends of the bending area 4315, but this may be an example. For example, in an embodiment, the protective layer 433 and the sensor layer 434 may extend substantially the same length as the shielding layer 435 and the first bonding layer 4371 at locations that overlap with the central portion of the bending area 4315. At the positions overlapping with the central portion of the bending area 4315, based the length direction of the electronic device 400 (e.g., the -Y-axis direction), the positions of the ends of the protective layer 433 and the sensor layer 434 may be substantially the same as the positions of the ends of the shielding layer 435 and the first bonding layer 4371.

Referring to FIG. 6B, the display 430 may have a positive step structure at a position that is not adjacent to the opposite ends of the bending area 4315 (e.g., the central portion of the bending area 4315). In an embodiment, the positive step structure may refer to a structure in which a layer located in a lower direction (e.g., the -Z-axis direction) of the protective layer 433 and the sensor layer 434 extend shorter toward the side wall 415 of the housing 410 compared to the protective layer 433 and the sensor layer 434.

In an embodiment, the opposite ends of the bending area 4315 may refer to the ends 4315a and 4315b of the bending area 4315 in the length direction of the bending area 4315 (e.g., the X-axis direction).

FIG. 6C may be a view illustrating the electronic device 400 viewed along line C-C' or line D-D' of FIG. 6A adjacent to the opposite ends 4315a and 4315b of the bending area 4315.

In an embodiment, the cross-section of the electronic device 400 viewed along line C-C' of FIG. 6A may be substantially the same as the cross-section of the electronic device 400 viewed along line D-D' of FIG. 6A.

In an embodiment, at the positions adjacent to the opposite ends of the bending area 4315, the shielding layer 435 and the first bonding layer 4371 may extend longer compared to the protective layer 433 and the sensor layer 434 in the length direction of the electronic device 400 (e.g., the -Y-axis direction). For example, referring to FIG. 6C, in an embodiment, at positions adjacent to the opposite ends of the bending area 4315, the ends of the shielding layer 435 and the first bonding layer 4371 may extend longer toward the side wall 415 of the housing 410 compared to the end of the protective layer 433 in the length direction of the electronic device 400 (e.g., the -Y-axis direction). In an embodiment, at positions adjacent to the opposite ends of the bending area 4315, the ends of the shielding layer 435 and the first bonding layer 4371 may extend longer toward the side wall 415 of the housing 410 compared to the end of the sensor layer 434 in the length direction of the electronic device 400 (e.g., the -Y-axis direction).

Referring to FIG. 6C, the display 430 may form a reverse step structure at a position adjacent to each of the opposite ends of the bending area 4315. In an embodiment, the reverse step structure may refer to a structure in which a layer located in the downward direction (e.g., the -Z-axis direction) of the protective layer 433 and the sensor layer 434 extend longer toward the side wall 415 of the housing 410 compared to the protective layer 433 and the sensor layer 434. In an embodiment, the reverse step structure may be formed by removing a portion of the protective layer 433 and the sensor layer 434 at a position adjacent to each of the opposite ends of the bending area 4315.

Referring to FIGS. 6B and 6C, according to an embodiment, the molding part 440 may be disposed on the inner surface of the bending area 4315. For example, the molding part 440 may be disposed to fill the space surrounded by the inner surface of the bending area 4315 and the resin layer 432, the protective layer 433, the sensor layer 434, the shielding layer 435, the first bonding layer 4371, the second bonding layer 4372, the third bonding layer 4373, and the fourth bonding layer 4374.

Referring to FIG. 6C, the molding part 440 may include a convex area 445 at a position adjacent to each of the opposite ends of the bending area 4315. The convex area 445 may be formed in a shape in which a portion of the molding part 440 protrudes in the +Y-axis direction.

Referring to FIG. 6C, the convex area 445 may be disposed to fill the space surrounded by the panel layer 431, the resin layer 432, the protective layer 433, the sensor layer 434, the shielding layer 435, and the first bonding layer 4371.

Referring to FIG. 6C, the convex area 445 of the molding part 440 may be disposed to fill the reverse step structure of the display 430 and may serve to alleviate the impact applied to the display 430. For example, the convex area 445 of the molding part 440 may be disposed to fill the reverse step structure of the display 430 and may serve to reduce the impact applied to the bending area 4315 of the display 430 in the length direction (e.g., the Y-axis direction) and the width direction (e.g., the X-axis direction) of the electronic device 400.

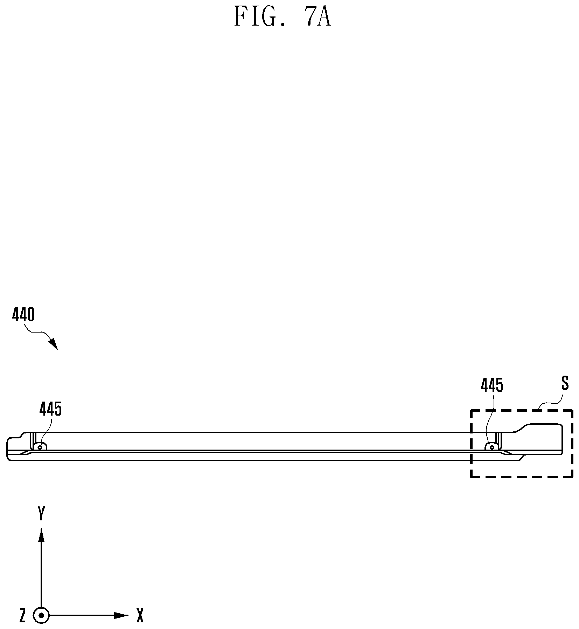

FIGS. 7A to 7C are views illustrating a molding part 440 according to an embodiment of the disclosure.

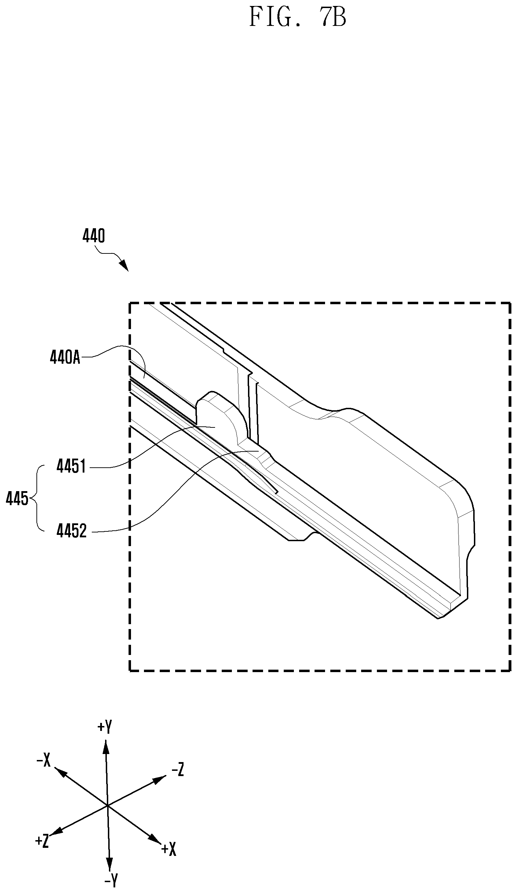

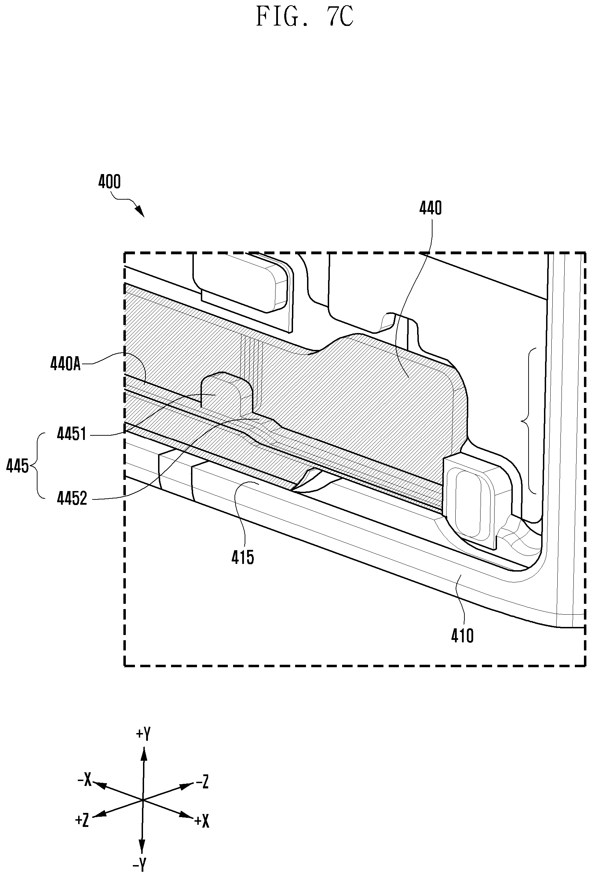

FIG. 7A is a plan view illustrating the molding part 440 according to an embodiment. FIG. 7B is a perspective view illustrating an S area illustrated in FIG. 7A. FIG. 7C is a view illustrating the molding part 440 disposed in a housing 410 according to an embodiment.

Referring to FIG. 7A, the molding part 440 may extend in the width direction (e.g., the X-axis direction) and the length direction (e.g., the Y-axis direction) of an electronic device 400. The molding part 440 may extend longer in the width direction of the electronic device 400 (e.g., the X-axis direction) than in the length direction of the electronic device 400 (e.g., the Y-axis direction).

Referring to FIG. 7A, the molding part 440 may include two convex areas 445.

In an embodiment, the two convex areas 445 may have substantially the same shape.

In an embodiment, the convex areas 445 may be provided at positions at least partially overlapping with the opposite ends 4315a and 4315b (see FIG. 6A) of the bending area 4315 (see FIG. 6A) of the display 430 (see FIG. 6A). For example, the convex areas 445 may at least partially overlap with the opposite ends 4315a and 4315b (see FIG. 6A) of the bending area 4315 (see FIG. 6A) in the length direction (e.g., the X-axis direction).

Referring to FIG. 7B, the convex area 445 may have a shape in which a portion of the molding part 440 protrudes compared to other areas of the molding part 440. For example, the convex area 445 may have a shape in which a portion of the molding part 440 protrudes compared to a reference surface 440A.

Referring to FIGS. 7B and 7C, the convex area 445 may be an area in which a portion of the molding part 440 protrudes in the +Y-axis direction compared to the reference surface 440A. In an embodiment, the convex area 445 may extend in the X-axis direction. The convex area 445 may have a thickness in the Z-axis direction.

Referring to FIG. 7B, the convex area 445 may include a first convex area 4451 and/or a second convex area 4452.

Referring to FIG. 7B, the first convex area 4451 may protrude more than the second convex area 4452.

In an embodiment, the convex area 445 may overlap with the opposite ends 4315a and 4315b (see FIG. 6A) of the bending area 4315 (see FIG. 6A) in the length direction (e.g., the X-axis direction) in the first convex area 4451.

Referring to FIG. 7C, the molding part 440 may be disposed in the housing 410. In an embodiment, the molding part 440 may be disposed in an end portion (e.g., the end portion in the -Y-axis direction) of the housing 410. In an embodiment, the molding part 440 may be formed by curing a molding material (e.g., silicone, epoxy, and/or poly methyl methacrylate (PMMA)) in an end portion (e.g., the end portion in the -Y-axis direction) of the housing 410.

Referring to FIG. 7C, the molding part 440 may be disposed to at least partially face the side wall 415 of the housing 410.

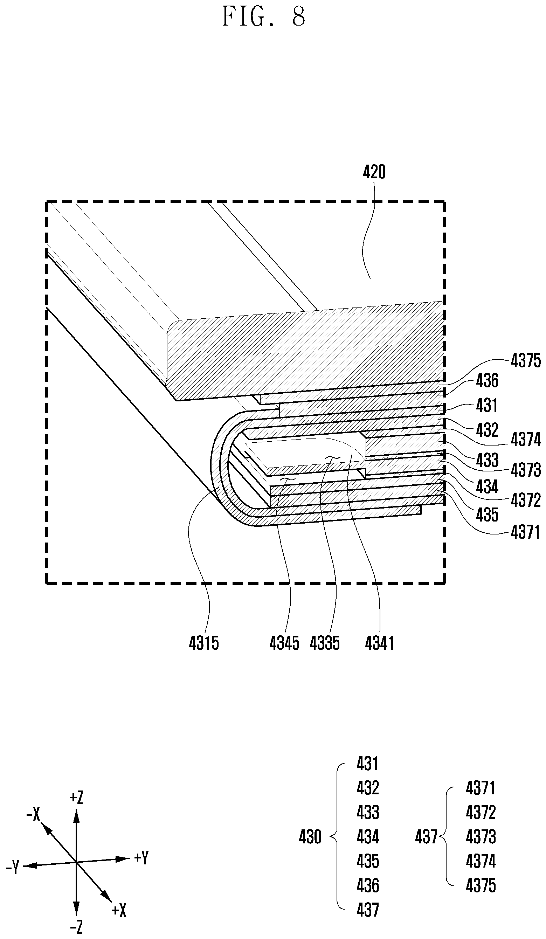

FIG. 8 is a cross-sectional perspective view illustrating a display 430 according to an embodiment of the disclosure.

FIG. 8 may be a cross-sectional perspective view illustrating the display 430 cut along line C-C' in FIG. 6A. For example, FIG. 8 may be a cross-sectional perspective view illustrating the display 430 cut the end portion of the bending area 4315 in the length direction (e.g., the X-axis direction).

FIG. 8 may be a view illustrating the display 430 before the molding part 440 (see FIG. 7B) is placed. For example, FIG. 8 may be a view illustrating the display 430 in the state in which the molding part 440 (see FIG. 7B) to be placed on the display 430 is omitted.

Referring to FIG. 8, the protective layer 433 may include a first concave area 4335.

In an embodiment, the first concave area 4335 may be a space formed by concavely carving a portion of the protective layer 433. In an embodiment, the first concave area 4335 may be formed by removing a portion of the protective layer 433.

In an embodiment, the first concave area 4335 may be provided at a position overlapping with each of the opposite ends 4315a and 4315b (see FIG. 6A) of the bending area 4315 in the length direction of the bending area 4315 (e.g., the X-axis direction).

In an embodiment, the molding part 440 (see FIG. 7B) may be disposed so that at least a portion thereof fills the first concave area 4335. For example, the convex area 445 (see FIG. 7B) of the molding part 440 (see FIG. 7B) may be filled into the first concave area 4335.

In an embodiment, at least a portion of the molding part 440 (see FIG. 7B) may be disposed to fill the first concave area 4335, and the display 430 may be fixed to the molding part 440 (see FIG. 7B). The display 430 may be fixed to the molding part 440 (see FIG. 7B), and the movement of the display 430 in the length direction (e.g., the Y-axis direction) and/or the width direction (e.g., the X-axis direction) of the electronic device 400 relative to the molding part 440 (see FIG. 7B) may be prevented or suppressed.

Referring to FIG. 8, the sensor layer 434 may include a second concave area 4345.

In an embodiment, the second concave area 4345 may be a space formed by concavely carving a portion of the sensor layer 434. In an embodiment, the second concave area 4345 may be formed by removing a portion of the sensor layer 434.

In an embodiment, the second concave area 4345 may be formed at a position overlapping with each of the opposite ends 4315a and 4315b (see FIG. 6A) of the bending area 4315 in the length direction of the bending area 4315 (e.g., the X-axis direction).

In an embodiment, the second concave area 4345 may be formed at a position overlapping with at least a portion of the first concave area 4335 in the downward direction (e.g., in the Z-axis direction).

In an embodiment, the molding part 440 (see FIG. 7B) may be disposed so that at least a portion thereof fills the second concave area 4345. For example, the convex area 445 (see FIG. 7B) of the molding part 440 (see FIG. 7B) may be filled into the second concave area 4345.

In an embodiment, at least a portion of the molding part 440 (see FIG. 7B) may be disposed to fill the second concave area 4345, and the display 430 may be fixed to the molding part 440 (see FIG. 7B). The display 430 may be fixed to the molding part 440 (see FIG. 7B), and the movement of the display 430 in the length direction (e.g., the Y-axis direction) and/or the width direction (e.g., the X-axis direction) of the electronic device 400 relative to the molding part 440 (see FIG. 7B) may be prevented or suppressed.

In an embodiment, the intermediate layer 4341 may include a portion of the third bonding layer 4373 positioned between the first concave area 4335 and the second concave area 4345 and/or a portion of the sensor layer 434.

In FIG. 8, the intermediate layer 4341 is illustrated as being positioned between the first concave area 4335 and the second concave area 4345, but this may be an example. For example, in an embodiment, the intermediate layer 4341 may not be positioned between the first concave area 4335 and the second concave area 4345. In an embodiment, the first concave area 4335 and the second concave area 4345 may be connected to each other.

In FIG. 8, the first concave area 4335 and the second concave area 4345 are illustrated as being formed at positions that overlap with the opposite ends 4315a and 4315b of the bending area 4315 (see FIG. 6A), but the positions where the first concave area 4335 and the second concave area 4345 are formed may not be limited thereto. In an embodiment, the first concave area 4335 and/or the second concave area 4345 may be formed at positions that do not overlap with the bending area 4315. For example, at least a portion of the end portion (e.g., the end portion oriented in the -Y-axis direction) of the protective layer 433 may be formed concavely at a position that does not overlap with the bending area 4315, and the first concave area 4335 may be formed. At least a portion of the end portion (e.g., the end portion oriented in the -Y-axis direction) of the sensor layer 434 may be formed concavely at a position that does not overlap with the bending area 4315, and the second concave area 4345 may be formed.

FIGS. 9A to 9D are views illustrating a display 430 according to an embodiment of the disclosure.

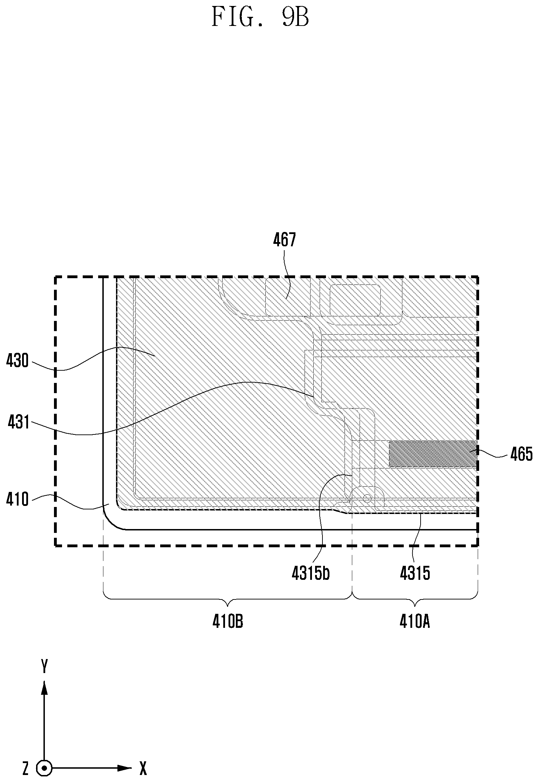

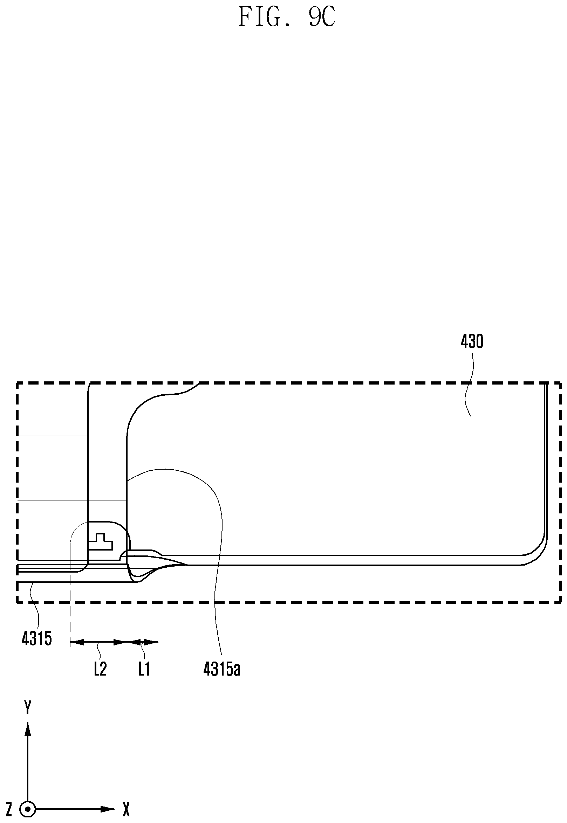

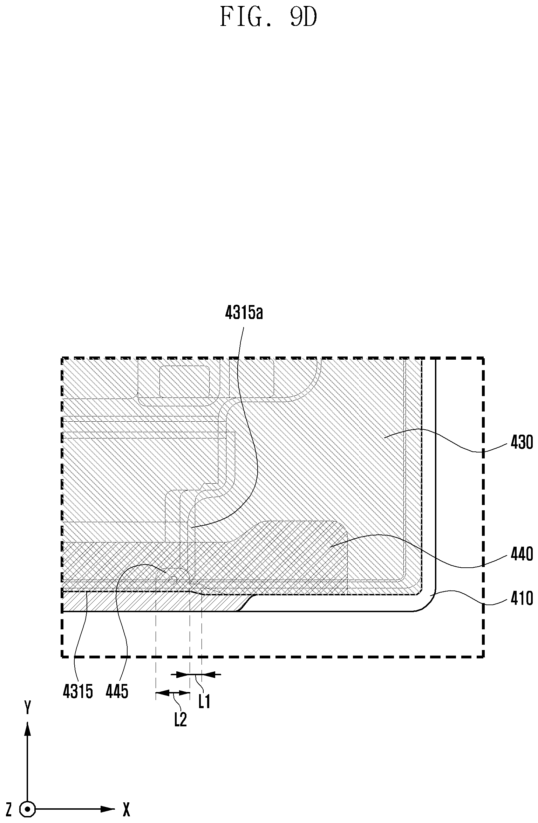

FIG. 9A is a view illustrating a first end 4315a of a bending area 4315 of the display 430. FIG. 9B is a view illustrating a second end 4315b of the bending area 4315 of the display 430. FIG. 9C is an enlarged view of the first end 4315a of the display 430 according to an embodiment. FIG. 9D is a view illustrating an electronic device 400 in which a molding part 440 is disposed.

Referring to FIG. 9A and FIG. 9B, the electronic device 400 may include a housing 410, a display 430, a control circuit 465, and/or a flexible printed circuit board 467.

In an embodiment, the display 430 may be placed in the housing 410.

In an embodiment, the control circuit 465 and the flexible printed circuit board 467 may be disposed on the panel layer 431 of the display 430.

In an embodiment, the control circuit 465 may include a display driver IC (DDI) and/or a touch display driver IC (TDDI).

In an embodiment, the flexible printed circuit board 467 is electrically connected to the panel layer 431 and may transmit a signal received from the control circuit 465 to a printed circuit board inside the electronic device 400.

In an embodiment, the control circuit 465 may be attached to the panel layer 431 in the form of a chip-on-panel (COP) structure or a chip-on-film (COF) structure. The chip-on-panel (COP) structure may refer to a structure in which the control circuit 465 is directly attached to the panel layer 431. The chip-on-film (COF) structure may refer to a structure in which the control circuit 465 is not directly attached to the panel layer 431, but is placed on the flexible printed circuit board 467. In FIGS. 9A and 9B, the control circuit 465 is illustrated as being arranged in the form of a chip-on-panel (COP) structure on the panel layer 431, but this may be an example. The control circuit 465 may also be placed in the form of a chip-on-film (COF) structure.

In an embodiment, the bending area 4315 of the panel layer 431 of the display 430 may extend from the first end 4315a to the second end 4315b along the length direction of the bending area 4315 (e.g., the X-axis direction). In an embodiment, the first end 4315a may be an end located opposite to the second end 4315b in the length direction of the bending area 4315 (e.g., the X-axis direction).

In an embodiment, the bending area 4315 of the panel layer 431 may extend between the first end 4315a and the second end 4315b. The bending area 4315 of the panel layer 431 may be an area formed to be at least partially bent between the first end 4315a and the second end 4315b.

Referring to FIGS. 9A and 9B, the first end 4315a and the second end 4315b of the bending area 4315 may be formed to have substantially the same shape with respect to the Y-axis.

Referring to FIGS. 9A and 9B, in an embodiment, the first part 410A of the housing 410 may be a portion of the housing 410 that faces the bending area 4315 of the display 430. For example, the first part 410A of the housing 410 may overlap with the bending area 4315. A second part 410B of the housing 410 may be a portion of the housing 410 that does not face the bending area 4315. For example, the second part 410B of the housing 410 may not overlap with the bending area 4315.

In an embodiment, the convex area 445 of the molding part 440 may be disposed at a position that at least partially overlaps with each of the opposite ends 4315a and 4315b of the bending area 4315. For example, referring to FIGS. 9C and 9D, the convex area 445 of the molding part 440 may be disposed at a position that overlaps with the first end 4315a of the bending area 4315.

In an embodiment, the convex area 445 of the molding part 440 may serve as a stopper that prevents the display 430 from moving relative to the molding part 440. The convex area 445 of the molding part 440 may be disposed at the position that overlaps with each of the opposite ends 4315a and 4315b of the bending area 4315, and the display 430 may be fixed to the molding part 440.

In an embodiment, the convex area 445 of the molding part 440 may extend by a predetermined length in a direction parallel to the length direction of the bending area 4315 (e.g., the X-axis direction) with respect to each of the opposite ends 4315a and 4315b of the bending area 4315. For example, referring to FIGS. 9C and 9D, the convex area 445 of the molding part 440 may extend by a first length L1 in a first direction (e.g., the +X-axis direction) with respect to the first end 4315a of the bending area 4315. The convex area 445 of the molding part 440 may extend by a second length L2 in a second direction (e.g., the -X-axis direction) opposite to the first direction (e.g., the +X-axis direction) with respect to the first end 4315a of the bending area 4315.

In an embodiment, the first length L1 may be a length within a range of 0.8 mm to 2.5 mm. For example, the first length L1 may be about 0.954 mm.

In an embodiment, the second length L2 may be a length within a range of 1.3 mm to 2.5 mm. For example, the second length L2 may be about 1.45 mm.

The second length L2 is illustrated as being greater than the first length L1 in FIGS. 9C and 9D, but this is an example, and the second length L2 and the first length L1 may not be limited thereto. For example, the first length L1 and the second length L2 may be substantially the same. In an embodiment, the first length L1 and the second length L2 may be about 2.5 mm in consideration of manufacturing tolerance.

In FIGS. 9C and 9D, only the first end 4315a of the bending area 4315 is illustrated, but this is an example for explanation. The convex area 445 of the molding part 440 may also extend by a predetermined length in a direction parallel to the length direction of the bending area 4315 (e.g., the X-axis direction) with respect to the second end 4315a of the bending area 4315. For example, the convex area 445 of the molding part 440 may extend by the second length L2 in a first direction (e.g., the +X-axis direction) with respect to the second end 4315b of the bending area 4315. The convex area 445 of the molding part 440 may extend by the first length L1 in a second direction (e.g., the -X-axis direction) with respect to the second end 4315b of the bending area 4315.

In an embodiment, when the convex area 445 of the molding part 440 extends by a predetermined length in the length direction of the bending part 4315 (e.g., the X-axis direction), the display 430 may be easily fixed to the molding part 440.

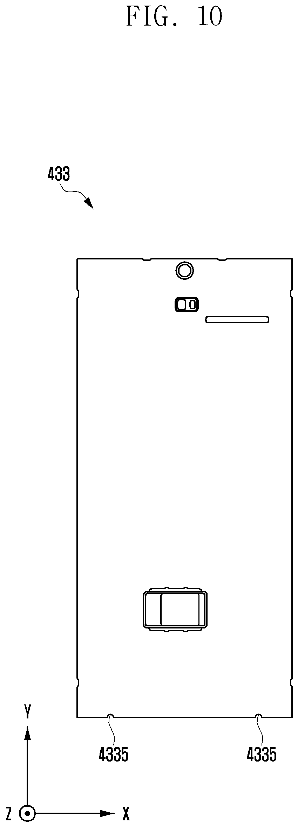

FIG. 10 is a view illustrating a protective layer 433 according to an embodiment of the disclosure.

Referring to FIG. 10, the protective layer 433 according to an embodiment may extend in the width direction (e.g., the X-axis direction) and the length direction (e.g., the Y-axis direction) of the electronic device 400 (see FIG. 4). The protective layer 433 may have a thickness in the height direction (e.g., the Z-axis direction) of the electronic device 400 (see FIG. 4).

In an embodiment, the protective layer 433 may include a first concave area 4335.

In an embodiment, the first concave area 4335 may be formed in an end portion of the protective layer 433. For example, the first concave area 4335 may be formed in an end portion of the protective layer 433 oriented in the -Y-axis direction.

In an embodiment, the first concave area 4335 may be a space in which a portion of the protective layer 433 is formed in a concavely carved shape. In an embodiment, the first concave area 4335 may be formed by removing a portion of the protective layer 433.

In an embodiment, the protective layer 433 may include two first concave areas 4335.

The two first concave areas 4335 may be formed at positions overlapping the opposite ends 4315a and 4315b (see FIGS. 9A and 9B) of the bending area 4315 (see FIG. 9A) of the display 430 (see FIG. 9A) in the length direction of the bending area 4315 (see FIG. 9A) (e.g., the X-axis direction).

In an embodiment, the protective layer 433 may serve to protect the panel layer 431 from an impact applied to the panel layer 431. In an embodiment, the protective layer 433 may include an emboss sheet and/or a cushion sheet.

In an embodiment, the sensor layer 434 (see FIG. 8) may be disposed on one surface of the protective layer 433. For example, the sensor layer 434 (see FIG. 8) may be disposed on a surface of the protective layer 433 oriented in the -Z-axis direction.

In an embodiment, the sensor layer 434 (see FIG. 8) may include two second concave areas 4345 (see FIG. 8) formed by concavely carving portions of the sensor layer 434 (see FIG. 8). The second concave areas 4345 (see FIG. 8) may be formed at positions overlapping the first concave areas 4335 with respect to the Z-axis direction.

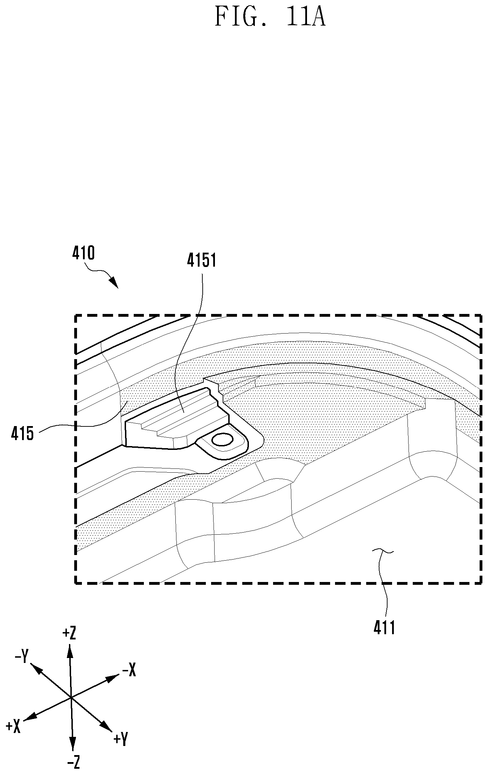

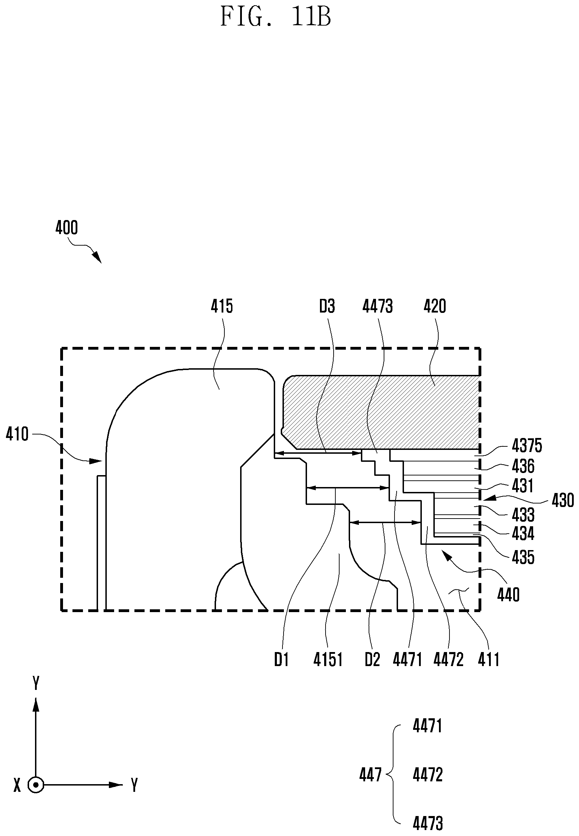

FIGS. 11A and 11B are views illustrating a side wall 415 of a housing 410 according to an embodiment of the present disclosure.

FIG. 11A is a view illustrating a step area 4151 formed on the side wall 415 according to an embodiment. FIG. 11B is a cross-sectional view illustrating the step area 4151 and a display 430 according to an embodiment.

FIG. 11B is a view illustrating the step area 4151 and the display 430 located in a portion corresponding to the second part 410B (see FIGS. 6A, 9A, and 9B) of the housing 410.

In an embodiment, the housing 410 may include a side wall 415 surrounding a placement space 411.

Referring to FIGS. 11A and 11B, the side wall (415) of the housing 410 according to an embodiment may include a step area 4151. In an embodiment, the step area 4151 may be an area in which at least a portion of a surface facing the placement space 411 is formed in a step shape.

In an embodiment, the step area 4151 may be formed in an area of the side wall 415 located in the second part 410B (see FIGS. 6A, 9A, and 9B) of the housing 410. For example, the step area 4151 may be formed in a portion of the housing 410 that does not face the bending area 4315.

Referring to FIG. 11B, the display 430 may be disposed to face the side wall 415 of the housing 410.

In an embodiment, the molding part 440 may include a molding area 447 formed at an end of the display 430 facing the step area 4151.

In an embodiment, the molding area 447 may be formed in a step shape at the end of the display 430.

In an embodiment, the molding area 447 may include a first molding area 4471, a second molding area 4472, and/or a third molding area 4473.

Referring to FIG. 11B, the first molding area 4471 may be formed at an end of the panel layer 431. The second molding area 4472 may be formed at an end of the protective layer 433. The third molding area 4473 may be formed at an end of the fifth bonding layer 4375.

In an embodiment, the distance between the molding area 447 and the housing 410 may vary depending on the position where the molding area 447 is formed. For example, the distance between the first molding area 4471 and the side wall 415 of the housing 410, and the distance between the second molding area 4472 and the side wall 415 of the housing 410 may be different.

In an embodiment, the first molding area 4471 and the step area 4151 of the side wall 415 may be spaced apart by a first distance D1 in the length direction of the electronic device 400 (e.g., the Y-axis direction). In an embodiment, the first distance D1 may range from 0.6 mm to 0.65 mm.

In an embodiment, the second molding area 4472 and the step area 4151 of the side wall 415 may be spaced apart by a second distance D2 in the length direction of the electronic device 400 (e.g., the Y-axis direction). In an embodiment, the second distance D2 may range from 0.4 mm to 0.55 mm.

In an embodiment, the third molding area 4473 and the step area 4151 of the side wall 415 may be spaced apart by a third distance D3 in the length direction of the electronic device 400 (e.g., the Y-axis direction). In an embodiment, the third distance D3 may range from 0.4 mm to 0.55 mm.

In an embodiment, the first distance D1, which is the distance between the first molding area 4471 and the step area 4151, may be greater than the second distance D2, which is the distance between the second molding area 4472 and the step area 4151.

In an embodiment, the first distance D1, which is the distance between the first molding area 4471 and the step area 4151, may be greater than the third distance D3, which is the distance between the third molding area 4473 and the step area 4151.

In an embodiment, the housing 410 and the molding part 440 may include at least a portion having a step shape to prevent or suppress an impact from being directly applied to the panel layer 431 of the display 430. For example, when an impact is applied to the electronic device 400, due to the step area 4151 and the molding area 447 formed in the step shape, other layers of the display 430 (e.g., the protective layer 433 and the fifth bonding layer 4375) may first come into contact with the housing 410 before the panel layer 431 come into contact with the housing 410, thereby preventing or suppressing an impact from being directly applied to the panel layer 431 of the display 430.

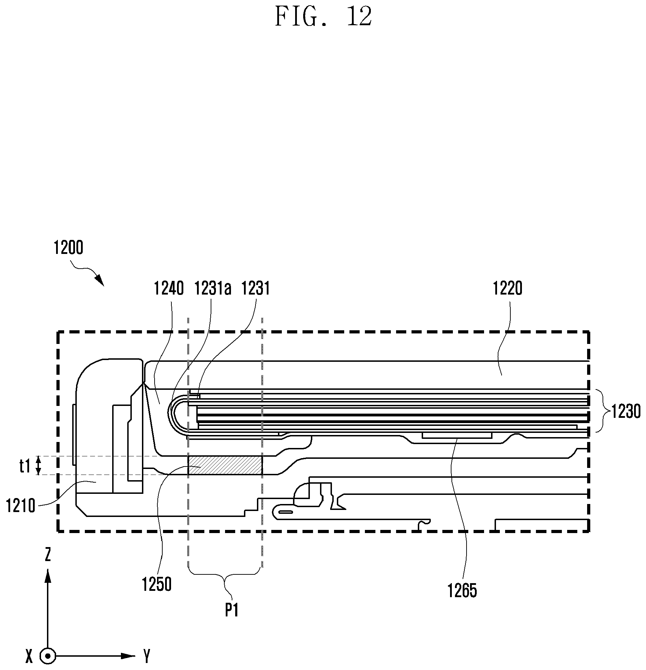

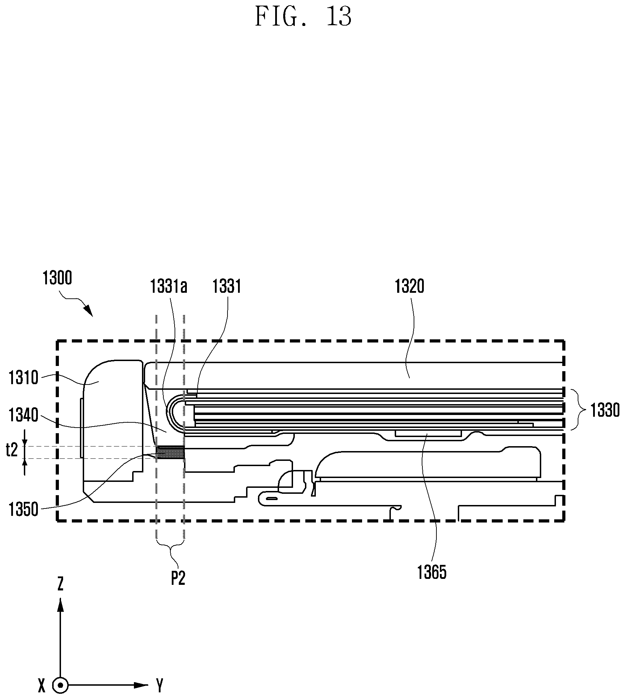

FIGS. 12 and 13 are views illustrating electronic devices 1200 and 1300 according to an embodiment of the disclosure.

FIG. 12 is a view showing an electronic device 1200 including a waterproof tape 1250 according to an embodiment. FIG. 13 is a view showing an electronic device 1300 including a bonding member 1350 according to an embodiment.

The electronic device 1200 of FIG. 12 may refer to the electronic device 400 of FIG. 5 or may include at least some of the components of the electronic device 400 of FIG. 5.

Referring to FIG. 12, the electronic device 1200 according to an embodiment may include a housing 1210, a window cover 1220, a display 1230, a molding part 1240, a waterproof tape 1250, and/or a control circuit 1265.

The housing 1210, the window cover 1220, the display 1230, and the molding part 1240 illustrated in FIG. 12 may be substantially the same as the housing 410, the window cover 420, the display 430, and the molding part 440 illustrated in FIG. 5, respectively. The control circuit 1265 illustrated in FIG. 12 may be substantially the same as the control circuit 465 illustrated in FIG. 9A.

In an embodiment, the display 1230 may include a panel layer 1231. The panel layer 1231 may include a bending area 1231a that bends and extends at an end thereof. In an embodiment, the molding part 1240 may be formed to surround the bending area 1231a.

In an embodiment, the waterproof tape 1250 may be placed on the molding part 1240. For example, referring to FIG. 12, the waterproof tape 1250 may be placed on the molding part 1240 across a first waterproof section P1. The waterproof tape 1250 may be located in the - Z-axis direction with respect to the molding part 1240. For example, the waterproof tape 1250 may be placed on a surface of the molding part 1240 oriented in the -Z-axis direction. The waterproof tape 1250 may have a thickness (e.g., t1) in the height direction of the electronic device 1200 (e.g., the Z-axis direction). The waterproof tape 1250 may extend in the length direction of the electronic device 1200 (e.g., the Y-axis direction).

The black masking (BM) area of the electronic device 1200 may reduce the active area (AA) area where an image is displayed on the display 1230 and may increase an unnecessary space in the electronic device 1200. When a waterproof member (e.g., the waterproof tape 1250) is placed on the molding part 1240 rather than on the window cover 1220, the black masking (BM) area of the electronic device 1200 may be reduced.

The electronic device 1300 of FIG. 13 may refer to the electronic device 400 of FIG. 5 or may include at least some of the components of the electronic device 400 of FIG. 5.

Referring to FIG. 13, the electronic device 1300 according to an embodiment may include a housing 1310, a window cover 1320, a display 1330, a molding part 1340, a bonding member 1350, and/or a control circuit 1365.

The housing 1310, the window cover 1320, the display 1330, and the molding part 1340 illustrated in FIG. 13 may be substantially the same as the housing 410, the window cover 420, the display 430, and the molding part 440 illustrated in FIG. 5, respectively. The control circuit 1365 illustrated in FIG. 13 may be substantially the same as the control circuit 465 illustrated in FIG. 9A.

In an embodiment, the display 1330 may include a panel layer 1331. The panel layer 1331 may include a bending area 1331a that bends and extends at an end thereof. In an embodiment, the molding part 1340 may be formed to surround the bending area 1331a.

In an embodiment, the bonding member 1350 may be placed on the molding part 1340. For example, referring to FIG. 13, the bonding member 1350 may be placed on the molding part 1340 across a second waterproof section P2. The bonding member 1350 may be located in the -Z-axis direction with respect to the molding part 1340. For example, the bonding member 1350 may be placed on a surface of the molding part 1340 oriented in the -Z-axis direction. The bonding member 1350 may have a thickness (e.g., t2) in the height direction of the electronic device 1300 (e.g., the Z-axis direction). The bonding member 1350 may extend in the length direction of the electronic device 1300 (e.g., the Y-axis direction).

Referring to FIG. 13, the second waterproof section P2 according to an embodiment may be located further outward (e.g., in the -Y-axis direction) relative to the first waterproof section P1 of FIG. 12 in the electronic device 1200 or 1300.

As the waterproof member (e.g., the waterproof tape 1250 or the bonding member 1350) is located further outward (e.g., in the -Y-axis direction) in the electronic device 1200 or 1300, the stress applied to the panel layer 1231 or 1331 of the display 1230 or 1330 may be reduced. The bonding member 1350 in the electronic device 1300 according to the embodiment illustrated in FIG. 13 is located outward (e.g., in the -Y-axis direction) with respect to the electronic device 1200 or 1300 compared to the waterproof tape 1250 in the electronic device 1200 according to the embodiment illustrated in FIG. 12, so that the stress applied to the panel layer 1331 can be further reduced.

In an embodiment, the bonding member 1350 may have a smaller thickness than the waterproof tape 1250. For example, the thickness of the bonding member 1350 may refer to the length by which the bonding member 1350 extends in the height direction of the electronic device 1300 (e.g., the Z-axis direction). The thickness of the waterproof tape 1250 may refer to the length by which the waterproof tape 1250 extends in the height direction of the electronic device 1200 (e.g., the Z-axis direction). The second thickness (e.g., t2), which is the thickness of the bonding member 1350, may be smaller than the first thickness (e.g., t1 in FIG. 12) of the waterproof tape 1250.

In an embodiment, the bonding member 1350 may include an adhesive formed with a smaller thickness compared to the tape.

When a molding part is placed in an end portion of a display of an electronic device, an air gap between the end portion of the display and other components of the electronic device may be reduced. When an impact is applied to the electronic device (e.g., when the electronic device is impacted by being dropped), the panel layer of the display may be damaged due to the reduction of the air gap. Since the opposite ends of a bending area of the display are vulnerable to an impact, it may be necessary to cushion the corresponding areas.

An electronic device 400 according to an embodiment of the present disclosure may include a housing 410, a display 430, and a molding part 440.

In an embodiment, the display 430 may be placed in the housing 410.

In an embodiment, the molding part 440 may be provided at an end portion of the display 430.

In an embodiment, the display 430 may include a panel layer 431 including a bending area 4315 in at least a portion of an end portion and a protective layer 433 disposed on the panel layer 431.

In an embodiment, the protective layer 433 may include a first concave area 4335 where at least a portion of an end portion of the protective layer 433 is formed concavely.

In an embodiment, the molding part 440 may be disposed to fill the first concave area 4335.

In an embodiment, the first concave area 4335 may be provided at a position overlapping with each end 4315a or 4315b of the bending area 4315 in the length direction of the bending area 4315 (e.g., the X-axis direction).

In an embodiment, the display 430 may further include a sensor layer 434 disposed on the protective layer 433.

In an embodiment, the sensor layer 434 may include a second concave area 4345 that is formed concavely at a position overlapping with the first concave area 4335.

In an embodiment, the molding part 440 may be disposed to fill the first concave area 4335 and the second concave area 4345.

In an embodiment, the molding part 440 may include a convex area 445 filled in the first concave area 4335 to fix the display 430 to the molding part 440.

In the electronic device 400 according to an embodiment of the disclosure, a molding stopper structure (e.g., the convex area 445 of the molding part 440) with a reverse step structure is applied to each end 4315a or 4315b of the bending area 4315. As a result, it is possible to prevent or suppress the display 430 from moving relative to the molding part 440 when an impact is applied to the electronic device 400.

In the electronic device 400 according to an embodiment of the disclosure, a molding stopper structure (e.g., the convex area 445 of the molding part 440) with a reverse step structure is applied to each end 4315a or 4315b of the bending area 4315. As a result, it is possible to prevent or suppress the display 430 from being damaged due to the movement of the display 430.

In an embodiment, the convex area 445 may be provided at a position overlapping with each end 4315a or 4315b of the bending area 4315 and may extend by a predetermined length in a first direction (e.g., the +X-axis direction) parallel to a length direction of the bending area 4315 and in a second direction (e.g., the 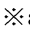 axis direction) opposite to the first direction from each end 4315a or 4315b of the bending area 4315.

In an embodiment, the panel layer 431 may include a first area 431a and a second area 431b spaced apart from the first area 431a in the height direction of the display.

In an embodiment, the bending area 4315 may connect the first area 431a and the second area 431b.

In an embodiment, the display 430 may further include a bonding layer (e.g., the first bonding area 4371) disposed between the second area 431b of the panel layer 431 and the protective layer 433.

In an embodiment, at a position overlapping with each end 4315a or 4315b of the bending area 4315, the bonding layer (e.g., the first bonding layer 4371) may extend longer toward the side wall 415 of the housing 410 compared to the protective layer 433 in the length direction of the electronic device 400.

In an embodiment, at a position overlapping with each end 4315a or 4315b of the bending area 4315, the bonding layer (e.g., the first bonding layer 4371) may extend longer toward the side wall 415 of the housing 410 compared to the sensor layer 434 in the length direction of the electronic device 400.

In an embodiment, the housing 410 may include a placement space 411 in which the display is placed and a side wall 415 surrounding the placement space 411.

In an embodiment, the side wall 415 may include a step area 4151 in which at least a portion of a surface of the side wall 415 facing the interior of the electronic device 400 is provided in a step shape.

In an embodiment, the molding part 440 may include a first molding area 4471 provided at an end of the panel layer 431, and a second molding area 4472 provided at an end of the protective layer 433.

In an embodiment, a first distance D1 between the step area 4151 and the first molding area 4471 may be longer than a second distance D2 between the step area 4151 and the second molding area 4472.

In an embodiment, the step area 4151 may be provided in an area of the side wall 415 that does not overlap with the bending area 4315 of the display 430.

In the electronic device 400 according to an embodiment of the disclosure, the step area 4151 is provided on a portion of the side wall 415 of the housing 410. As a result, it is possible to prevent or suppress an impact from being directly applied to the panel layer 431 of the display 430.

In an embodiment, the display 430 may include a polarizing layer 436 disposed on the panel layer 431, a sensor layer 434 including a sensor circuit configured to detect the operation of an external input device and disposed on the protective layer 433, and a shielding layer 435 disposed on the sensor layer 434 and configured to shield noise.

In an embodiment, the electronic device may include a window cover 420 on which the display 430 is placed, and the molding part 440 may be provided such that at least a portion thereof fills a space between the end portion of the display 430 and the window cover 420.

In an embodiment, the housing 410 may include a placement space 411 and a side wall 415 surrounding the placement space 411.

In an embodiment, the display 430 may be placed in the placement space 411 and face the side wall 415.

In an embodiment, the molding part 440 may be provided at an end portion of the display 430.

In an embodiment, the display 430 may include a panel layer 431, and a protective layer 433 disposed on the panel layer 431.

In an embodiment, the molding part 440 may include a first molding area 4471 provided at an end of the panel layer 431, and a second molding area 4472 provided at an end of the protective layer 433.

In an embodiment, a first distance D1 between the side wall 415 and the first molding area 4471 may be longer than a second distance D2 between the side wall 415 and the second molding area 4472.

In an embodiment, the display 430 may include a bonding layer (e.g., the fifth bonding layer 4375) disposed between the panel layer 431 and the window cover 420.

In an embodiment, the molding part 440 may further include a third molding area 4473 provided at an end of the bonding layer (e.g., the fifth bonding layer 4375), and the first distance D1 between the side wall 415 and the first molding area 4471 may be longer than the third distance D3 between the side wall 415 and the third molding area 4473.

In an embodiment, the panel layer 430 may include a bending area 4315 in at least a portion of an end portion thereof, and the first molding area 4471 and the second molding area 4472 are provided at a position that does not overlap with the bending area 4315.

The technical subjects pursued in the disclosure may not be limited to the above-mentioned technical subjects, and other technical subjects which are not mentioned may be clearly understood from the following descriptions by those skilled in the art to which the disclosure pertains.

Advantageous effects obtainable from the disclosure may not be limited to the above-mentioned effects, and other effects which are not mentioned may be clearly understood from the following descriptions by those skilled in the art to which the disclosure pertains.

The electronic device according to an embodiment of the disclosure may be one of various types of electronic devices. The electronic device may include, for example, a portable communication device (e.g., a smart phone), a computer device, a portable multimedia device, a portable medical device, a camera, a wearable device, or a home appliance. The electronic device according to embodiments of the disclosure is not limited to those described above.

It should be appreciated that an embodiment of the disclosure and the terms used therein are not intended to limit the technological features set forth herein to particular embodiments and the disclosure includes various changes, equivalents, or alternatives for a corresponding embodiment. With regard to the description of the drawings, similar reference numerals may be used to designate similar or relevant elements. A singular form of a noun corresponding to an item may include one or more of the items, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. Such terms as "a first," "a second," "the first," and "the second" may be used to simply distinguish a corresponding element from another, and does not limit the elements in other aspect (e.g., importance or order). If an element (e.g., a first element) is referred to, with or without the term "operatively" or "communicatively", as "coupled with/to" or "connected with/to" another element (e.g., a second element), it means that the element may be coupled/connected with/to the other element directly (e.g., wiredly), wirelessly, or via a third element.

As used in an embodiment of the disclosure, the term "module" may include a unit implemented in hardware, software, or firmware, and may be interchangeably used with other terms, for example, "logic," "logic block," "component," or "circuit". The "module" may be a single integrated component, or a minimum unit or part thereof, adapted to perform one or more functions. For example, according to an embodiment, the "module" may be implemented in the form of an application-specific integrated circuit (ASIC).

An embodiment of the disclosure may be implemented as software (e.g., the program 101) including one or more instructions that are stored in a storage medium (e.g., the internal memory 136 or external memory 138) that is readable by a machine (e.g., the electronic device 140). For example, a processor (e.g., the processor 120) of the machine (e.g., the electronic device 101) may invoke at least one of the one or more instructions stored in the storage medium, and execute it. This allows the machine to be operated to perform at least one function according to the at least one instruction invoked. The one or more instructions each may include a code generated by a complier or a code executable by an interpreter. The machine-readable storage medium may be provided in the form of a non-transitory storage medium. Herein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, the method according to an embodiment of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., Play Store TM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each element (e.g., a module or a program) of the above-described elements may include a single entity or multiple entities, and some of the multiple entities may also be separately disposed in another element. According to an embodiment, one or more of the above-described elements may be omitted, or one or more other elements may be added. Alternatively or additionally, a plurality of elements (e.g., modules or programs) may be integrated into a single element. In such a case, according to various embodiments, the integrated element may still perform one or more functions of each of the plurality of elements in the same or similar manner as they are performed by a corresponding one of the plurality of elements before the integration.

According to various embodiments, operations performed by the module, the program, or another element may be carried out sequentially, in parallel, repeatedly, or heuristically, or one or more of the operations may be executed in a different order or omitted, or one or more other operations may be added.

## Claims

1. An electronic device (400) comprising:
a housing (410);
a display (430) placed in the housing; and
a molding part (440) provided at an end portion of the display,
wherein the display comprises:
a panel layer (431) comprising a bending area (4315) in at least a portion of an end portion; and
a protective layer (433) disposed on the panel layer,
wherein the protective layer comprises a first concave area (4335) where at least a portion of an end portion of the protective layer is formed concavely, and
wherein the molding part is disposed to fill the first concave area.

2. The electronic device of claim 1, wherein the first concave area is provided at a position overlapping with each end (4315a, 4315b) of the bending area in a length direction of the bending area.

3. The electronic device of claim 1, wherein the display further comprises a sensor layer (434) disposed on the protective layer,
wherein the sensor layer comprises a second concave area (4345) that is formed concavely at a position overlapping with the first concave area, and
wherein the molding part is disposed to fill the first concave area and the second concave area.

4. The electronic device of claim 1, wherein the molding part comprises a convex area (445) filled in the first concave area to fix the display to the molding part, and
wherein the convex area is provided at a position overlapping with each end of the bending area and extends by a predetermined length in a first direction parallel to a length direction of the bending area and in a second direction opposite to the first direction from each end of the bending area.

5. The electronic device of claim 1, wherein the panel layer comprises a first area (431a) and a second area (431b) spaced apart from the first area in a height direction of the display,
wherein the bending area connects the first area and the second area, and
wherein the display further comprises a bonding layer (4371) disposed between the second area of the panel layer and the protective layer.

6. The electronic device of claim 5, wherein at a position overlapping with each end (4315a, 4315b) of the bending area, the bonding layer extends longer toward the side wall (415) of the housing compared to the protective layer in a length direction of the electronic device.

7. The electronic device of claim 5, wherein the display further comprises a sensor layer (434) disposed on the protective layer, and
wherein, at a position overlapping with each end (4315a, 4315b) of the bending area, the bonding layer extends longer toward the side wall (415) of the housing compared to the sensor layer in a length direction of the electronic device.

8. The electronic device of claim 1, wherein the housing comprises a placement space (411) in which the display is placed and a side wall (415) surrounding the placement space, and
wherein the side wall comprises a step area (4151) in which at least a portion of a surface of the side wall facing an interior of the electronic device is provided in a step shape.

9. The electronic device of claim 8, wherein the molding part comprises:
a first molding area (4471) provided at an end of the panel layer; and
a second molding area (4472) provided at an end of the protective layer, and
wherein a first distance (D1) between the step area and the first molding area is longer than a second distance (D2) between the step area and the second molding area.

10. The electronic device of claim 8, wherein the step area is provided in an area of the side wall that does not overlap with the bending area of the display.

11. The electronic device of claim 1, further comprising:
a window cover (420) on which the display is placed,
wherein the molding part is provided such that at least a portion thereof fills a space between the end portion of the display and the window cover.

12. An electronic device comprising:
a housing (410) comprising a placement space (411) and a side wall (415) surrounding the placement space;
a display (430) placed in the placement space and facing the side wall; and
a molding part (440) provided at an end portion of the display,
wherein the display comprises:
a panel layer (431); and
a protective layer (433) disposed on the panel layer, and
wherein the molding part comprises:
a first molding area (4471) provided at an end of the panel layer; and
a second molding area (4472) provided at an end of the protective layer, and
wherein a first distance (D1) between the side wall and the first molding area is longer than a second distance (D2) between the side wall and the second molding area.

13. The electronic device of claim 12, wherein the side wall comprises a step area (4151) in which at least a portion of a surface of the side wall facing an interior of the electronic device is provided in a step shape, and
wherein the first distance between the step area and the first molding area is longer than the second distance between the step area and the second molding area.

14. The electronic device of claim 12, further comprising:
a window cover (420) which covers the placement space and on which the display is disposed,
wherein the display further comprises a bonding layer (4375) disposed between the panel layer and the window cover,
wherein the molding part further comprises a third molding area (4473) provided at an end of the bonding layer, and
wherein the first distance between the side wall and the first molding area is longer than the third distance (D3) between the side wall and the third molding area.

15. The electronic device of claim 12, wherein the panel layer comprises a bending area (4315) in at least a portion of an end portion thereof, and
wherein the first molding area and the second molding area are provided at a position that does not overlap with the bending area.
